# EUROPEAN PATENT SPECIFICATION

(11) **EP 0 447 556 B1**
(45) Date of publication and mention of the grant of the patent: **17.11.1994**
(21) Application number: 90914416.4
(22) Date of filing: 28.09.1990
(51) Int. Cl.: C23C 14/06

(54) **SURFACE-COATED HARD MEMBER HAVING EXCELLENT ABRASION RESISTANCE**
OBERFLÄCHENBESCHICHTETER HARTWERKSTOFF MIT AUSGEZEICHNETER VERSCHLEISSFESTIGKEIT
ELEMENT DUR REV TU EN SURFACE PRESENTANT D'EXCELLENTES CARACTERISTIQUES DE RESISTANCE A L'ABRASION

(30) Priority: 29.09.1989 JP 254489/89; 15.05.1990 JP 125153/90
(43) Date of publication of application: 25.09.1991
(73) Proprietor: SUMITOMO ELECTRIC INDUSTRIES, LTD., Osaka-shi, Osaka 541 (JP)
(72) Inventor: OMORI, Naoya, c/o Itami Works of Sumitomo, Itami-shi, Hyogo 664 (JP); YAMAGATA, Kazuo, c/o Itami Works of Sumitomo, Itami-shi, Hyogo 664 (JP); NOMURA, Toshio, c/o Itami Works of Sumitomo, Itami-shi, Hyogo 664 (JP); TOBIOKA, Masaaki, c/o Itami Works of Sumitomo, Itami-shi, Hyogo 664 (JP)
(74) Representative: Allard, Susan Joyce
(86) International application number: JP9001256
(87) International publication number: WO9105074

(56) References cited:
- JP-A- 5 941 466
- JP-A-51 151 277
- JP-A-55 150 941
- CHEMICAL ABSTRACTS, vol. 99, no. 22, November 1983, page 275, abstract no.180283y, Columbus, Ohio, US; & JP-A-58 136 770

## Description

This invention relates to a surface-coated hard material in which a hard coating layer is provided on the surface of a substrate of various hard materials such as cutting tools and wear reistance tools so as to improve the wear resistance.

The hard materials such as various wear resistance parts including cutting tools and wear resistance tools are generally composed of cemented carbides based on tungsten carbide (WC), various cermets based on titanium carbide (TiC) and steels such as high-speed steels or hard alloys.

In order to improve the wear resistnace of the hard material, a surface-coated hard material has been developed and has lately been put to practical use in which one or more layers of carbides, nitrides or carbonitrides of Ti, Hf or Zr or oxide of Al are formed, as hard coating layers, on the surface of the hard material by a PVD method or CVD method.

In the above described surface-coated hard materials, however, the wear resistance cannot be said sufficient and in particular, cutting tools or wear resistance tools such as end mills or throwaway inserts have shortened lives because of poor wear resistance.

JP-A-51-151277 discloses a cemented carbide article having a coating film comprising a carbide, nitride or oxide of Si, Al or a Group IVa or Group Va element of the Periodic Table, or a solid solution thereof. JP-A-59-041466 discloses a substrate having a plurality of coating layers applied thereto, the coating layer applied to the substrate comprising TiC, TiCN or TiN. JP-A-55-150941 discloses a cutting tool having a coating film formed of a carbide, nitride or oxide of B, Si, Al, or a Group IVa, Va or Vla element of the Periodic Table.

Under the situation, the present invention has been made for the purpose of providing a surface-coated hard material having more excellent wear reisistance than that of the prior art, particularly suitable for use as a cutting tool or wear resistance tool.

That is to say, the feature of the surface-coated hard material according to the present invention consists in having a hard coating layer with a thickness of 0.5 to 10 µm, composed of at least one member selected from the group consisting of carbides, nitrides and carbonitrides of alloys of Hf and Al on a substrate consisting of a hard material.

The hard coating layer can be provided on the whole surface of a substrate or on only a part of the surface requiring a wear reistance. Formation of the hard coating layer can be carried out in known manner, for example, by sputtering methods, ion plating methods, CVD methods, etc.

As well known in the art, carbides, nitrides and carbonitrides of Hf, commonly used as a hard coating layer, each have a high bonding strength to a hard material as a substrate and an excellent oxidation resistance similarly to carbides, nitrides and carbonitrides of Ti, but have not such an excellent high temperature hardness, nor such a high wear resistance. On the other hand, carbides, nitrides and carbonitrides of Al are somewhat inferior in the bonding strength to substrates, oxidation resistance and hardness to the carbides, nitrides and carbonitrides of Hf or Ti.

As a result of our studies on the wear resistance and bonding strength as to various hard coating layers on hard materials, it is found that the carbides, nitrides and carbonitrides of alloys of Hf and Al are in the form of crystalline grains rendered finer than the carbides, nitrides and carbonitrides of Hf alone and thus capable of giving a largely improved wear resistance. Furthermore, it is found that when high speed cutting is carried out using the surface-coated hard material having this hard coating layer as a cutting tool or wear resistance tool, the wear resistance is not lowered even in the high speed cutting because of formation of Al₂O₃ having a very high hardness at a high temperature due to rising of the edge temperature.

The hard coating layer consisting of the carbides, nitrides and carbonitrides of Hf-Al alloys can be provided in the form of either a monolayer or multilayer and the layer thickness should preferably be in the range of 0.5 to 10 µm, particularly 0.5 to 8 µm, since if the layer thickness is less than 0.5 µm, the wear resistance is not so improved, while if more than 10 µm, the residual stress in the layer is increased and the bonding stress is lowered.

However, the hard coating layer consisting of the carbides, nitrides and carbonitrides of Hf-Al alloys is somewhat inferior in bonding strength to substrate and oxidation resistance to the carbides, nitrides and carbonitrides of Hf or Ti.

Accordingly, when a bonding strengthening layer consisting of at least one of carbides, nitrides and carbonitrides is directly formed between the surface of a substrate and the hard coating layer, the bonding strength of the hard caoting layer to the substrate surface can largely be improved. In this case, if the thickness of the bonding strengthening layer is less than 0.5 µm, the the bonding strength is not improved, while even if more than 5 µm, the bonding strength is not further improved.

Even when an oxidation resistance at a high temperature is required, a surface layer consisting of at least one of carbides, nitrides and carbonitrides of Hf or Ti is formed on the surface of the above described hard coating layer, thereby obtaining an excellent oxidation resistance at a high temperature and improved wear resistance. When the thickness of the surface layer is less than 0.5 µm, the wear resistance is hardly improved and even if more than 2 µm, further improvement of the wear resistance cannot be achieved.

Formation of the coating layers, i.e. the hard coating layer, bonding strengthening layer and surface layer can be carried out by the commonly used methods, for example, PVD methods and CVD methods, but the PVD methods such as sputtering methods and ion plating methods are preferred from the standpoint of readily maintaining the strength of the substrates.

### Example 1

Using a cutting insert made of a cemented carbide with a composition of JIS standard P 30 (specifically, WC-20 wt % TiC-10 wt % Co) and a form of JIS SNG 432 as a substrate, the surface thereof was coated with each of coating layers as shown in the following Table 1 by an ion plating method using vacuum arc discharge, as described below, thus obtaining samples of surface-coated cutting inserts according to the present invention.

Namely, the above described cutting insert and Ti, Hf, HfAl or Hf₃Al as a target were arranged in a film making apparatus, in which the insert was then maintained in an Ar gas atmosphere with a vacuum degree of 1.33 Pa (1 x 10 ⁻² torr), rinsed by applying a voltage of -2000 V and heated at 500 °C, after which the Ar gas was exhausted. While introducing one or both of N₂ gas and CH₄ gas at a rate of 300 cm³/min into the film making apparatus, the above described target was evaporated and ionized by vacuum arc discharge and each of the coating layers shown in Table 1 was formed on the surface of the cutting insert.

For comparison, the surface of a cutting insert with the same composition and same form as described above was coated with the coating layers of TiC, TiN and TiCN individually or in combination by an ion plating method using the same film making apparatus and vacuum arc discharge as described above, thereby obtaining samples of surface-coated cutting inserts of the prior art as shown in Table 1:

**Table 1**

| Sample | Composition and Thickness (µm) of Coating Layer | | |
|---|---|---|---|
| | Bonding Strengthening Layer | Hard Coating Layer | Surface Layer |
| 1 | - | HfAlN (4.0) | - |
| 2 | - | HfAlCN (4.5) | - |
| 3 | - | Hf₃AlC (3.5) | - |
| 4 | - | Hf₃AlN (4.0) | - |
| 5 | - | HfAlN(1.0)+HfAlCN(2.0)+HfAlC(1.0) | - |
| 6 | | Hf₃AlN(1.0)+HfAlC(2.5)+Hf₃AlC(1.0) | - |
| 7 | TiN (1.5) | HfAlC (3.5) | - |
| 8 | TiCN (2.0) | HfAlCN (3.2) | - |
| 9 | HfN (1.5) | Hf₃AlN (2.8) | - |
| 10 | TiC (1.5) | Hf₃AlCN (3.0) | - |
| 11 | HfCN (1.8) | HfAlCN (3.2) | - |
| 12 | HfC (2.0) | Hf₃AlC (2.8) | - |
| 13 | TiN (2.0) | HfAlN (3.2) | TiN (2.5) |
| 14 | TiCN (2.3) | HfAlCN (3.6) | HfN (1.8) |
| 15 | HfN (2.0) | Hf₃AlC (3.5) | HfC (2.0) |
| 16 | TiC (2.0) | Hf₃AlCN (3.0) | TiCN (1.8) |
| 17 | HfC (2.2) | HfAlC (3.2) | HfCN (1.5) |
| 18 | HfCN (1.8) | Hf₃AlN (3.5) | TiC (1.2) |
| 19 | TiN (1.0) | HfAlN(1.0)+HfAlCN(2.0)+HfAlN(1.0) | TiCN (1.2) |
| 20 | HfCN (1.0) | Hf₃AlN(1.0)+HfAlC(2.5)+Hf₃AlCN(1.0) | HfC (1.0) |
| 21* | - | TiC (3.0) | - |
| 22* | - | TiN (5.0) | - |
| 23* | | TiCN (3.0) | - |
| 24* | TiN (1.0) | TiCN (5.0) | TiN (1.0) |

| | | | |
|---|---|---|---|
| (Note) * prior art (similarly defined hereinafter) | | | |

Each of the samples of the surface-coated cutting inserts prepared as described above was subjected to a continuous cutting test and intermittent cutting test under conditions as shown in Table 2. In the former test, the flank wear width and crater depth of the edge were measured and the wear state was observed, and in the latter test, the limit of feed rate was measured.

**Table 2**

| Cutting Conditions | | |
|---|---|---|
| | Continuous Cutting Test | Intermittent Cutting Test |
| Workpiece | SCM 435 | SCM 435 |
| Cutting Speed | 160 m/min | 216 m/min |
| Feed | 0.37 mm/rev | |
| Cutting Depth | 2.0 mm | 1.5 mm |
| Cutting Time | 15 min | |

The results of the above described cutting tests are shown in Table 3.

**Table 3**

| Sample | Flank Wear Width (mm) | Crater Depth (µm) | Wear State of Coating Layer | Limit of Feed Rate (mm/rev) |
|---|---|---|---|---|
| 1 | 0.16 | 34 | somewhat stripped | 0.40 |
| 2 | 0.15 | 40 | -do- | 0.35 |
| 3 | 0.15 | 42 | -do- | 0.40 |
| 4 | 0.14 | 30 | -do- | 0.40 |
| 5 | 0.12 | 33 | -do- | 0.40 |
| 6 | 0.11 | 32 | -do- | 0.40 |
| 7 | 0.11 | 35 | normal wear | 0.45 |
| 8 | 0.12 | 38 | -do- | 0.40 |
| 9 | 0.13 | 32 | -do- | 0.45 |
| 10 | 0.12 | 30 | -do- | 0.45 |
| 11 | 0.11 | 31 | -do- | 0.40 |
| 12 | 0.12 | 34 | -do- | 0.45 |
| 13 | 0.09 | 30 | -do- | 0.30 |
| 14 | 0.08 | 28 | -do- | 0.35 |
| 15 | 0.08 | 26 | -do- | 0.40 |
| 16 | 0.09 | 26 | -do- | 0.40 |
| 17 | 0.08 | 26 | -do- | 0.35 |
| 18 | 0.07 | 28 | -do- | 0.45 |
| 19 | 0.07 | 25 | -do- | 0.45 |
| 20 | 0.06 | 28 | -do- | 0.45 |
| 21* | 0.36 | 80 | stripped | 0.35 |
| 22* | 0.34 | 60 | -do- | 0.45 |
| 23* | 0.31 | 75 | -do- | 0.40 |
| 24* | 0.29 | 60 | normal wear | 0.45 |

From these results, it will clearly be understood that Samples Nos. 1 to 20 of the surface-coated cutting inserts according to the present invention have more excellent wear resistance, toughness and edge breakage resistance than Sample Nos. 21 to 24 of the surface-coated cutting inserts of the prior art in both the continuous cutting test and intermittent cutting test. In particular, Sample Nos. 7 to 20 exhibit higher bonding strengths to substrates and Sample Nos. 13 to 20 have more improved wear resistances due to the higher oxidation resistances of the surface layers.

### Example 2

Using a cutting insert made of a cemented carbide with a composition of JIS standard P 30 (specifically, WC-20 wt % TiC-10 wt % Co) and a form of JIS SNG 432 as a substrate, the surface thereof was coated with each of coating layers as shown in the following Table 4 by an ion plating method using vacuum arc discharge, as described below.

Namely, the above described cutting insert and HfAl or Hf₃Al as a target were arranged in a film making apparatus, in which the insert was then maintained in an Ar gas atmosphere with a vacuum degree of 1.33 Pa (1 x 10 ⁻² torr), rinsed by applying a voltage of -2000 V and heated at 500 °C, after which the Ar gas was exhausted. While introducing one or both of N₂ gas and CH₄ gas at a rate of 300 cm³/min into the film making apparatus, the above target HfAl or Hf₃Al was evaporated and ionized by vacuum arc discharge and the hard coating layer was thus formed on the surface of the cutting insert to prepare each of the samples of the coated cutting inserts shown in Table 4.

Each of the resulting coated cutting insert samples having the hard coating layers was subjected to a continuous cutting test (measurement of the flank wear width and crater depth of the edge) and an intermittent cutting test (limitation of the feed) under the same conditions as those of Example 1, thus obtaining resutlts shown in Table 4.

**Table 4**

| Sample No. | Composition and Thickness of Hard Coating Layer | | | Flank Wear Width (mm) | Crater Depth (µm) | Limit of Feed Rate (mm/rev) |
|---|---|---|---|---|---|---|
| | Inner Layer (µm) | Middle Layer (µm) | Outer Layer (µm) | | | |
| 25 | no | no | HfAlC (4) | 0.14 | 40 | 0.35 |
| 26 | no | no | Hf₃AlCN (4) | 0.14 | 40 | 0.40 |
| 27 | HfAlN (1) | HfAlCN (2) | HfAlN (1) | 0.14 | 37 | 0.45 |
| 28 | Hf₃AlN (2) | Hf₃AlCN (2) | Hf₃AlN (1) | 0.12 | 28 | 0.45 |
| 29 | Hf₃AlN (1) | Hf₃AlCN (1) | Hf₃AlCN (2) | 0.11 | 30 | 0.45 |
| (Note) Sample Nos. 25-29: coated cutting inserts according to the present invention | | | | | | |

It will be apparent from the above described results that the cutting insert sample of the present invention has more excellent properties, that is, a higher wear resistance in the continuous cutting test and a comparable toughness in the intermittent cutting test, as compared with the coated cutting insert of the prior art.

### Utility and Possibility on Commercial Scale

According to the present invention, there is provided a surface-coated hard material having a novel hard coating layer whereby a more excellent wear resistance is given than that of the prior art.

When using the surface-coated hard material of the present invention for cutting tools or wear resistance tools, therefore, a good cutting performance can be maintained for a long period of time.

## Claims

1. A surface-coated hard material having an excellent wear resistance, in which at least one hard coating layer consisting of at least one material which is a carbide, nitride or carbonitride of an alloy of hafnium and aluminium is provided on the surface of a substrate.

2. A surface-coated hard material having an excellent wear resistance, in which a hard coating layer having a thickness of 0.5 to 10 µm and consisting of at least one material which is a carbide, nitride or carbonitride of an alloy of Hf and Al is provided on the surface of a substrate consisting of a hard material.

3. A surface-coated hard material as claimed in claim 1, wherein a strengthening layer having a thickness of 0.5 to 5 µm and consisting of at least one material which is a carbide, nitride or carbonitride of Hf or Ti is directly formed on the surface of the substrate beneath the hard coating layer.

4. A surface-coated hard material as claimed in claim 1 or claim 2, wherein an additional layer having a thickness of 0.5 to 2 µm and consisting of at least one material which is a carbide, nitride or carbonitride of Hf or Ti is provided on the surface of the hard coating layer.

## Patentansprüche

1. Oberflächenbeschichtetes Hartmaterial mit ausgezeichnetem Verschleißwiderstand, bei dem mindestens eine Hartbeschichtungslage auf der Oberfläche einer Grundlage zur Verfügung gestellt wird, wobei die Hartbeschichtung aus mindestens einem Material besteht, welches ein Carbid, Nitrid oder Carbonitrid einer Hafnium- und Aluminiumlegierung darstellt.

2. Oberflächenbeschichtetes Hartmaterial mit ausgezeichnetem Verschleißwiderstand, bei dem eine Hartbeschichtung mit einer Dicke von 0,5 bis 10 µm auf der Oberfläche einer aus einem Hartmaterial bestehenden Grundlage zur Verfügung gestellt wird, wobei die Hartbeschichtung aus mindestens einem Material besteht, welches ein Carbid, Nitrid oder Carbonitrid einer Hafnium- und Aluminiumlegierung ist.

3. Oberflächenbeschichtetes Hartmaterial gemäß Anspruch 1, bei dem eine festigende Schicht mit einer Dicke von 0,5 bis 5 µm direkt auf der Oberfläche der Grundlage und unterhalb der Hartbeschichtung gebildet wird, wobei diese Schicht aus mindestens einem Material besteht, welches ein Hf- oder Ti-Carbid, -Nitrid oder -Carbonitrid darstellt.

4. Oberflächenbeschichtetes Hartmaterial gemäß Anspruch 2, bei dem eine zusätzliche Schicht mit einer Dicke von 0,5 bis 2 µm auf der Oberfläche der Hartbeschichtung zur Verfügung gestellt wird, wobei diese zusätzliche Schicht aus mindestens einem Material besteht, welches ein Hf- oder Ti-Carbid, -Nitrid oder -Carbonitrid darstellt.

## Revendications

1. Matière dure de revêtement de surface ayant une excellente résistance à l'usure, dans laquelle au moins une couche de revêtement dure, constituée d'au moins une matière qui est un carbure, un nitrure ou un carbonitrure d'un alliage d'hafnium et d'aluminium, est déposée sur la surface d'un substrat.

2. Matière dure de revêtement de surface, ayant une excellente résistance à l'usure, dans laquelle une couche de revêtement dure ayant une épaisseur de 0,5 à 10 µm, et constituée d'au moins une matière qui est un carbure, un nitrure ou un carbonitrure d'un alliage de Hf et d'Al, est déposée sur la surface d'un substrat constitué d'une matière dure.

3. Matière dure de revêtement de surface, selon la revendication 1, dans laquelle une couche de renforcement ayant une épaisseur de 0,5 à 5 µm, et constituée d'au moins une matière qui est un carbure, un nitrure ou un carbonitrure de Hf ou de Ti, est directement formée sur la surface du substrat sous la couche de revêtement dure.

4. Matière dure de revêtement de surface, selon la revendication 1 ou la revendication 2, dans laquelle une couche supplémentaire ayant une épaisseur de 0,5 à 2 µm, et constituée d'au moins une matière qui est un carbure, un nitrure ou un carbonitrure de Hf ou de Ti, est déposée sur la surface de la couche de revêtement dure.
